Europäisches Patentamt

European Patent Office

Office européen des brevets

(11) Veröffentlichungsnummer: **0 042 878**
**B1**

(12) **EUROPÄISCHE PATENTSCHRIFT**

(45) Veröffentlichungstag der Patentschrift:
**19.02.86**

(21) Anmeldenummer: **80103585.8**

(22) Anmeldetag: **25.06.80**

(51) Int. Cl.⁴: **G 01 R 31/28,** G 01 R 35/02,
G 01 R 19/32, G 01 R 15/04,
H 01 F 40/14, H 02 H 3/16,
H 04 B 1/60

(54) **Überwachungsvorrichtung für eine Messverstärkerstrecke.**

(43) Veröffentlichungstag der Anmeldung:
**06.01.82 Patentblatt 82/1**

(45) Bekanntmachung des Hinweises auf die Patenterteilung:
**19.02.86 Patentblatt 86/8**

(84) Benannte Vertragsstaaten:
**AT BE CH FR GB IT LI LU NL SE**

(56) Entgegenhaltungen:
**DE - B - 2 049 259
DE - C - 971 557
US - A - 3 555 415**

**F. VILBIG: "Hochfrequenz-Messtechnik", 1953, CARL
HANSER VERLAG, München, DE**

(73) Patentinhaber: **Kommanditgesellschaft Ritz
Messwandler GmbH & Co.,
Postfach 2959 Salomon-Heine-Weg 72,
D-2000 Hamburg 20 (DE)**

(72) Erfinder: **Ruf, Dieter, Dipl.-Ing., Heilwisch 27,
D-2000 Hamburg 65 (DE)**

(74) Vertreter: **Stach, Harald, Dr. Dipl.-Chem. et al,
Adenauerallee 30, D-2000 Hamburg 1 (DE)**

## Beschreibung

Die Erfindung betrifft eine Messverstärkerschaltung für eine Spannungsmesseinrichtung für mehrphasige Hochspannungsanlagen, mit einem jeweils eine Primär-Hochspannung in eine niedrigere Eingangsspannung umwandelnden kapazitiven Spannungsteiler, jeweils einen Vorverstärker und einen Endverstärker aufweisenden Verstärkerstrecken, Vorrichtungen zur Überwachung der Eingangs- und Ausgangsspannungen jeder Verstärkerstrecke sowie Vorrichtungen zu deren Ersatz.

Bei Hochspannungsnetzen und Energieverteilungsnetzen werden ausserordentlich hohe Ansprüche an die Zuverlässigkeit und Verfügbarkeit der entsprechenden Bauteile gestellt. Von der Funktionsfähigkeit der zugeordneten Messgeräte hängt das Abschalten ganzer Netzbereiche ab. Die Ausfallswahrscheinlichkeit elektronischer Komponenten ist so hoch, dass die dadurch bedingte Fehlerhäufigkeit nicht in dem geforderten Bereich liegt.

Bei der aus der DE-C 971 557 bekannten Messverstärkerschaltung der eingangs genannten Art mit einer stark gegengekoppelten Röhrenverstärkeranordnung können die Röhrenstufen jeweils doppelt vorgesehen sein, wobei eine Überwachungseinrichtung jeweils bei Ausfall einer Röhrenstufe auf die Ersatz-Röhrenstufe umschaltet.

Dabei ist jedoch für jede Röhrenstufe eine eigene Ersatz-Röhrenstufe erforderlich. Abgesehen davon, dass Röhrenverstärker heutigen Anforderungen nicht mehr genügen, ist es bei der bekannten Schaltung nicht möglich, durch Vergleich der Spannungswerte zuverlässig festzustellen, welcher der Spannungswerte messtechnisch richtig ist.

In F. Vilbig «Hochfrequenz-Messtechnik», 1953, Seiten 668 und 669 ist ferner eine Überwachungsvorrichtung beschrieben, bei der an die gegenüberliegenden Plattenpaare einer Braun'schen Röhre die Eingangs- und Ausgangsspannungen einer Verstärkerschaltung zum optischen Vergleich angelegt werden, wobei eine Bedienungsperson das sich ergebende Bild mit einem von Messungen an einer Verstärkerstrecke mit den gewünschten Eigenschaften bekannten Bild vergleichen muss. Dies erlaubt jedoch keinen selbsttätigen Vergleich der Eingangs- und Ausgangsspannung und keine selbsttätige Fehlerbehebung.

Aus der DE-B-2 049 259 ist schliesslich ein System zur selbsttätigen Prüfung von Video-Studiogeräten bekannt, bei welchem in die Video-Signale während der vertikalfrequenten Austastlücke Testsignale eingeblendet und spezifische Video-Übertragungsparameter überprüft werden. Diese bekannte Schaltung besitzt jedoch weder Verstärkereinrichtungen, noch Vergleicheinrichtungen für Istwerte und Sollwerte.

Aufgabe der Erfindung ist es nun, eine Messverstärkerschaltung der eingangs genannten Art zu schaffen, die eine zuverlässige Erkennung der jeweils schadhaften Verstärkerstrecke und eine selbsttätige Zuschaltung der Ersatz-Verstärkerstrecke gewährleistet.

Zur Lösung dieser Aufgabe ist die Messverstärkerschaltung der eingangs genannten Art erfindungsgemäss gekennzeichnet durch die Merkmale des Patentanspruchs 1.

Diese Messverstärkerschaltung ermöglicht eine einfache und zuverlässige Überwachung der Funktionsfähigkeit der Verstärkerstrecken mit selbsttätiger Fehlererkennung und -behebung. Der Mikrocomputer ermittelt, welche Verstärkerstrecke schadhaft ist, und schaltet selbsttätig die Ersatz-Verstärkerstrecke an deren Stelle. Bei einem 3-phasigen Netz werden anstelle von acht Verstärkerstrecken nur noch fünf benötigt. Wenn man mehr als fünf Verstärkerstrecken vorsieht, wird die Zuverlässigkeit noch vergrössert.

Vorteilhafte weitere Ausgestaltungen der Messverstärkerschaltung sind in den Unteransprüchen beschrieben.

Der Mikrocomputer ist vorzugsweise auf den Vergleich digitalisierter Ist- und Sollwerte ausgelegt und kann zusätzlich andere Aufgaben erfüllen, wodurch die Anwendungsmöglichkeiten stark erweitert werden. Die Spannungsvergleichsschaltung kann auch einen analogen Komparator und einen Differenzverstärker aufweisen. Die Messverstärkerschaltung kann zusätzlich eine Verstärkerstrecke mit einer Vorrichtung zur Erfassung von Erdschlüssen aufweisen.

Da Veränderungen der Betriebsbedingungen des Spannungsteilers, nämlich die Temperatur oder der Gasdruck einer $SF_6$-Atmosphäre zu Änderungen der Eingangsgrösse in die Verstärkerstrecke führen, können im Spannungsteiler zweckmässig Sensoren zur Erfassung der Temperatur und/oder des Gasdruckes vorgesehen sein, deren Messwerte dem Mikrocomputer zugeführt werden, um dadurch verursachte Effekte zu kompensieren. Der Mikrocomputer kann die entsprechenden Informationen über Temperatur und/oder Gasdruck verarbeiten und in geeigneter Weise den Verstärkungsfaktor der Verstärkerstrecke einregulieren, um somit trotz Änderungen der Eingangsgrösse den gewünschten Ausgangswert zu erhalten.

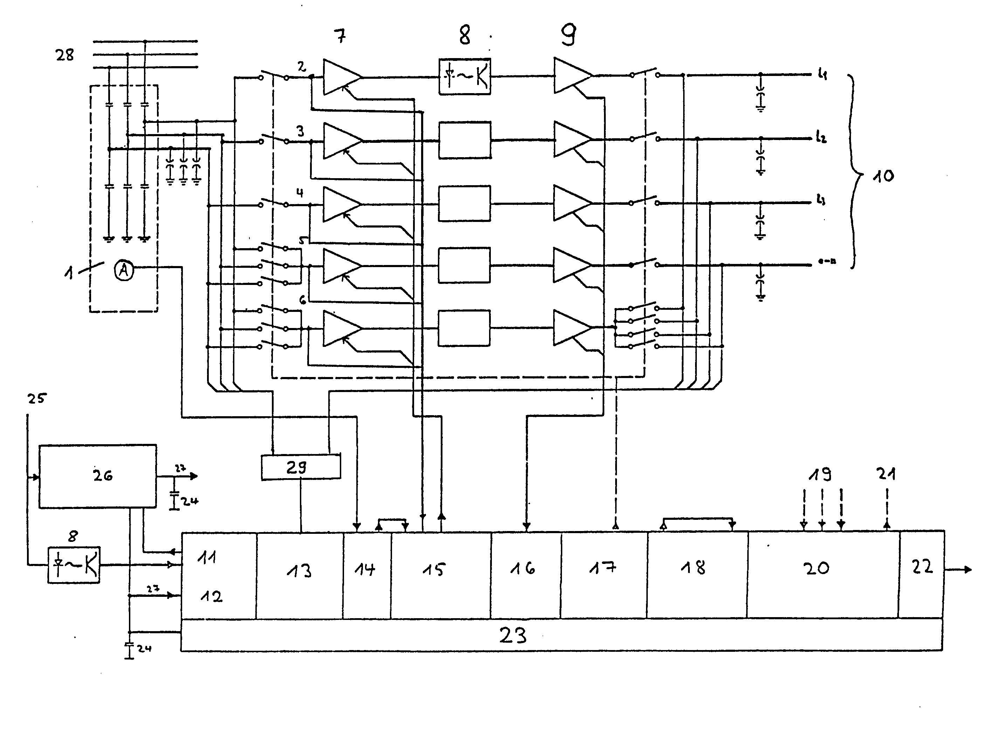

Im folgenden wird eine bevorzugte Ausführungsform der Messverstärkerschaltung anhand der beigefügten Zeichnung weiter erläutert.

Diese zeigt ein Schaltbild mit einem 3-phasigen Hochspannungsnetz 28, dessen Spannungen zu Messzwecken über einen kapazitiven Spannungsteiler 1 heruntergespannt werden. An diesem werden über die Verstärkerstrecken 2, 3, 4, 5 und 6 Spannungen abgegriffen, wobei die Verstärkerstrecken 2, 3 und 4 je einer Phase des Hochspannungsnetzes 28 zugeordnet sind und die Verstärkerstrecke 5 die geometrische Summe aus den drei Phasen erfasst, so dass ein Erdschluss festgestellt werden kann. Die Ersatz-Verstärkerstrecke 6 ist zum Ersatz einer ausgefallenen Verstärkerstrecke vorgesehen. Der Verstärkerstrecke 2 ist ein Schalter zur Verbindung mit der ersten Phase, der Verstärkerstrecke 3 ein Schalter zur Verbindung mit der zweiten Phase und der Verstärkerstrecke 4 ein Schalter zur Verbindung mit der dritten Phase zugeordnet und für die Verstärkerstrecke 5 ein Schalter vorgesehen, der mit allen drei Phasen gleichzeitig verbindet. Der Ersatz-Verstärkerstrecke 6 sind drei Schalter zugeordnet, die wahlweise entweder gemeinsam mit allen drei Phasen oder jeweils einzeln mit einer der Phasen verbinden können. Mit den einzelnen Phasen muss verbunden werden, wenn die Ersatz-Verstärkerstrecke 6 eine der Verstärkerstrecken 2 bis 4 ersetzen soll. Mit allen drei Phasen gleichzeitig muss verbunden werden, wenn die Ersatz-Verstärkerstrecke 6 an die Stelle der Verstärkerstrecke 5 treten soll.

Die Verstärkerstrecken weisen einen Vorverstärker 7 auf, der zur leistungslosen Anpassung an den kapazitiven Teiler dient, die Kapazität des Kabels zwischen dem kapazitiven Teiler und dem Vorverstärker kompensiert und die Einstellung des zweckmässigen Frequenzbereiches zur Unterdrückung von Störungen ermöglicht. Der Vorverstärker 7 besitzt im betriebsmässigen Frequenzbereich (in der Regel 50 Hz) einen hohen und bei Gleichspannungen einen niedrigen Eingangswiderstand. Der niedrige Eingangswiderstand für Gleichspannungen dient dazu, Restladungen auf den Teilerkapazitäten bei Netzabschaltungen kurzfristig abzubauen.

Dem Vorverstärker 7 folgt eine Potentialtrennstufe 8, die das Auftreten von Erdschleifen zwischen dem Vorverstärker 7 und dem Endverstärker 9 verhindern soll. Auf die Potentialtrennstufe 8 folgt der Endverstärker 9, der ein Leistungsverstärker ist. Auch bei nichtohm'scher Belastung muss die Signaltreue dieses Endverstärkers 9 nach Betrag und Phase erhalten bleiben. Die Verstärkerstrecken 2, 3, 4 und 5 sind durch einen Endschalter von den nachgeschalteten Anordnungen $L_1$, $L_2$, $L_3$ und e-n (versehen mit dem Bezugszeichen 10) trennbar, während die Ersatz-Verstärkerstrecke 6 durch vier einzeln betätigbare Schalter je nach Bedarf wahlweise mit einem der Zweige $L_1$, $L_2$, $L_3$ oder e-n verbunden werden kann.

Die Eingangsspannungen werden vor der Zuführung zu den Vorverstärkern und die Ausgangsspannungen hinter den Endverstärkern 9 abgenommen. Die beiden zusammengehörenden Grössen werden jeweils einer Bewertungsschaltung 29 zugeführt, in der sie in eine für den Vergleich geeignete Darstellung gebracht werden. Die Bewertungsschaltung 29 kann beispielsweise ein Widerstandsnetzwerk sein, mit dessen Hilfe Eingangs- und Ausgangsspannung auf identische Werte gebracht werden, um anschliessend in einem analogen Komparator verglichen zu werden. Es ist natürlich genau so möglich, die Messwerte zu digitalisieren und sie dann im Mikrocomputer 23 zu vergleichen.

Der Mikrocomputer 23 besitzt Bereiche 11 und 12 zur Überwachung und Steuerung der eigenen Stromversorgung von der Stationsbatterie 25 über das Schaltnetzteil 26, das den Mikrocomputer mit den Versorgungsspannungen 27 versorgt. Mit 24 sind Puffer bezeichnet, die einen kurzzeitigen Netzausfall überbrücken können. Die Spannungs-Vergleichsschaltung 13 des Mikrocomputers dient zum Vergleich der Istwerte der Eingangs- und Ausgangsspannung und zum Vergleich des Ist-Vergleichswerts mit einem Sollwert sowie zur Abgabe eines logischen Signals, falls eine Abweichung des Ist-Vergleichswerts vom Sollwert auftritt.

Im Spannungsteiler können Sensoren A untergebracht werden, die beispielsweise zur Erfassung der Temperatur im Spannungsteiler oder zur Erfassung des Gasdrucks dienen, falls eine $SF_6$-Atmosphäre verwendet wird. Diese Parameter beeinflussen das Teilerverhältnis und somit die Eingangsspannung in die Vorverstärker. Der Mikrocomputer 23 berechnet den Korrekturfaktor zur Kompensierung des Temperaturganges des kapazitiven Teilers und kann dann über seinen Bereich 15 zum Ausgleich der äusseren Parameter den Verstärkungsfaktor der Vorverstärker 7 beeinflussen. Mit Hilfe des Bereichs 15 kann die Eingangsspannung überwacht und der Verstärkungsfaktor darauf abgestimmt werden. Der Bereich 16 des Mikrocomputers 23 überwacht die Belastung der Ausgangsspannung und der Bereich 17 betätigt die Schaltorgane, mit denen die einzelnen Verstärkerstrecken 2 bis 6 ein- und aus- bzw. umgeschaltet werden. Wenn beispielsweise die Verstärkerstrecke 2 als schadhaft erkannt wird, werden der Eingangs- und der Ausgangsschalter der Verstärkerstrecke 2 aufgetrennt und zum Zuschalten der Ersatz-Verstärkerstrecke 6 der an die der Verstärkungsstrecke 2 zugeordneten Phase angeschlossene Eingangsschalter eingeschaltet und der Ausgangsschalter betätigt, der mit den durch die Verstärkungsstrecke 2 anzusteuernden Messvorrichtungen verbunden ist. Somit ersetzt die Ersatz-Verstärkerstrecke 6 die Verstärkerstrecke 2. Eine Prüfroutine 18 des Mikrocomputers 23 dient zur Selbstüberwachung. Über die Stromeingänge 19 können dem Bereich 20 Aussagen über die in den Leitern fliessenden Ströme zugeführt werden, so dass im Bereich 20 Netzzustandsberechnungen möglich sind. An den Ausgang 21 können Zähler oder Relais angeschlossen werden. Ein Alarmausgang 22 informiert über den Ausfall von Verstärkerstrecken.

**Patentansprüche**

1. Messverstärkerschaltung für eine Spannungsmesseinrichtung für mehrphasige Hochspannungsanlagen, mit einem jeweils eine Primär-Hochspannung in eine niedrigere Eingangsspannung umwandelnden kapazitiven Spannungsteiler (1), jeweils einen Vorverstärker (7) und einen Endverstärker (9) aufweisenden Verstärkerstrecken (2, 3, 4), für die vom Spannungsteiler (1) gelieferten Eingangsspannungen, Vorrichtungen zur Überwachung der Eingangs- und Ausgangsspannungen jeder Verstärkerstrecke (2, 3, 4), sowie Vorrichtungen zu deren Ersatz, dadurch gekennzeichnet, dass

a) eine an die Stelle jeder beliebigen Verstärkerstrecke (2, 3, 4) zuschaltbare, identische Ersatz-Verstärkerstrecke (6) vorgesehen ist,

b) die Überwachungsvorrichtungen eine die Eingangsspannung und die Ausgangsspannung jeder Verstärkerstrecke (2, 3, 4) aufnehmende Bewertungsschaltung (29) und eine als Teil eines Mikrocomputers (23) ausgebildete Spannungs-Vergleichsschaltung (13) umfassen,

c) die Spannungs-Vergleichsschaltung (13) über den Vergleich der Istwerte der Eingangsspannung und der Ausgangsspannung hinaus zum Vergleich des dabei erhaltenen Ist-Vergleichswerts mit einem Sollwert und zur Abgabe eines logischen Signals bei Abweichung des Ist-Vergleichswerts vom Sollwert ausgelegt ist und

d) dem die jeweils schadhafte Verstärkerstrekke (2, 3, 4) erfassenden Mikrocomputer (23) eine jeweils auf das logische Signal der Spannungs-Vergleichsschaltung (13) betätigte Umschaltvorrichtung (17) zum Einschalten der Ersatz-Verstärkerstrecke (6) an die Stelle der ausgefallenen Verstärkerstrecke (2, 3, 4) zugeordnet ist.

2. Messverstärkerschaltung nach Anspruch 1, dadurch gekennzeichnet, dass der Mikrocomputer (23) zum Vergleich digitalisierter Ist- und Sollwerte ausgelegt ist.

3. Messverstärkerschaltung nach Anspruch 1 oder 2, dadurch gekennzeichnet, dass der Mikrocomputer mit die Temperatur und/oder den Gasdruck im Spannungsteiler (1) erfassenden Sensoren (A) verbunden und zum automatischen Ausgleich von durch Temperatur oder Gasdruck beeinflussten Messwerten ausgelegt ist.

4. Messverstärkerschaltung nach einem der Ansprüche 1–3, dadurch gekennzeichnet, dass eine weitere Verstärkerstrecke (5) mit einer Vorrichtung zur Erfassung von Erdschlüssen verbunden ist.

## Claims

1. Monitoring amplifier circuit for a voltage measuring device for multiphase high voltage installations, with a capacitive voltage divider (1) transforming a primary high voltage each into a lower input voltage, amplifier lines (2, 3, 4) for the input voltages provided by the voltage divider (1) and each comprising a preamplifier (7) and a final amplifier (9), devices for monitoring the input and output voltages of each amplifier line (2, 3, 4), and devices for the replacement thereof, characterized in that

a) an identical replacement amplifier line (6) connectable instead of each amplifier line (2, 3, 4) is provided,

b) the monitoring devices comprise an evaluation circuit (29) receiving the input voltage and the output voltage of each amplifier line (2, 3, 4), and a voltage comparison circuit (13) embodied as a part of a microcomputer (23),

c) the voltage comparison circuit (13) is laid out, in excess of the comparison of the actual values of the input voltage and the output voltage, for comparison of the actual comparison value obtained thereby with a desired value and for output of a logical signal on deviation of the actual comparison value from the desired value, and

d) a switching device (17) for connecting the replacement amplifier line (6) instead of the failed amplifier line (2, 3, 4), actuated in response to the logical signal of the voltage comparison circuit (13) is coordinated to the microcomputer (23) detecting the faulty amplifier line (2, 3, 4).

2. Monitoring amplifier circuit according to claim 1, characterized in that the microcomputer (23) is laid out for comparison of digitalized actual and desired values.

3. Monitoring amplifier circuit according to claim 1 or 2, characterized in that the microcomputer is connected with sensors (A) detecting the temperature and/or the gas pressure in the voltage divider (1), and is laid out for automatic compensation of monitoring values influenced by temperature or gas pressure.

4. Monitoring amplifier circuit according to any one of the claims 1 to 3, characterized in that a further amplifier line (5) is connected with a device for the detection of earth faults.

## Revendications

1. Circuit amplificateur de mesure pour un dispositif de mesure de tension destiné à des installations haute tension polyphasées, avec un diviseur de tension capacitif (1) convertissant chacune des hautes tensions primaires de phases en une tension d'entrée plus basse, avec des sections d'amplification (2, 3, 4), comportant chacune un pré-amplificateur (7) et un amplificateur terminal (9) pour chacune des tensions d'entrée délivrées par le diviseur de tension (1), avec des dispositifs pour surveiller les tensions d'entrée et de sortie de chaque section d'amplification (2, 3, 4) ainsi qu'avec des dispositifs pour remplacer ces sections d'amplification, circuit amplificateur de mesure caractérisé en ce que:

a) il est prévu une section d'amplification de remplacement (6) identique, susceptible d'être branchée à la place de n'importe laquelle des sections d'amplification (2, 3, 4),

b) les dispositifs de surveillance comportent un circuit d'exploitation (29) captant la tension d'entrée et la tension de sortie de chaque section d'amplification (2, 3, 4), et un circuit de comparaison de tension (13) faisant partie d'un micro-calculateur (23),

c) le circuit de comparaison de tension (13) est pour comparer, avec une valeur de consigne, la valeur de comparaison réelle obtenue par comparaison des valeurs réelles de la tension d'entrée et de la tension de sortie, et pour délivrer un signal logique lorsque cette valeur de comparaison réelle s'écarte de la valeur de consigne,

d) un dispositif de commutation (17) actionné par le signal logique du circuit de comparaison de tension (13) est associé au micro-calculateur (23) détectant la section d'amplification (2, 3, 4) respectivement défectueuse, pour brancher la section d'amplification de remplacement (6) à la place de la section d'amplification (2, 3, 4) défaillante.

2. Circuit amplificateur de mesure selon la revendication 1, caractérisé en ce que le microcalculateur (23) est prévu pour la comparaison de valeurs réelles et de valeurs de consigne mises sous forme numérique.

3. Circuit amplificateur de mesure selon la revendication 1 ou 2, caractérisé en ce que le microcalculateur est relié à des détecteurs (A) détectant la température et/ou la pression de gaz dans le diviseur de tension (1), et est prévu pour compenser automatiquement les valeurs de mesure influencées par la température et la pression de gaz.

4. Circuit amplificateur de mesure selon une des revendications 1 à 3, caractérisé en ce qu'une autre section d'amplification (5) est reliée à un dispositif pour détecter les mises à la terre.